# EUROPÄISCHE PATENTSCHRIFT

(11) **EP 2 417 618 B1**
(45) Veröffentlichungstag und Bekanntmachung des Hinweises auf die Patenterteilung: **27.03.2013**
(21) Anmeldenummer: 10722019.6
(22) Anmeldetag: 06.04.2010
(51) Int. Cl.: H01J 37/244, H01J 37/256, H01J 37/28

(54) **DETEKTOR, VORRICHTUNG UND VERFAHREN ZUR GLEICHZEITIGEN, ENERGIEDISPERSIVEN AUFNAHME VON RÜCKSTREUELEKTRONEN UND RÖNTGENQUANTEN**
DETECTOR, DEVICE, AND METHOD FOR THE SIMULTANEOUS, ENERGY-DISPERSIVE RECORDING OF BACKSCATTERED ELECTRONS AND X-RAY QUANTA
DÉTECTEUR, DISPOSITIF ET PROCÉDÉ D'ENREGISTREMENT SIMULTANÉ À DISPERSION D'ÉNERGIE D'ÉLECTRONS RÉTRODISPERSÉS ET DE RAYONS X

(30) Priorität: 06.04.2009 DE 102009016702; 05.06.2009 DE 102009024928
(43) Veröffentlichungstag der Anmeldung: 15.02.2012
(73) Patentinhaber: Bruker Nano GmbH, 12489 Berlin (DE)
(72) Erfinder: TERBORG, Ralf, 10317 Berlin (DE)
(74) Vertreter: Gulde Hengelhaupt Ziebig & Schneider
(86) Internationale Anmeldenummer: PCT/EP2010/054509
(87) Internationale Veröffentlichungsnummer: WO 2010/115873

(56) Entgegenhaltungen:
- EP-A2- 1 227 315
- WO-A1-81/03707
- GB-A- 2 295 454
- JP-A- 3 216 581
- JP-A- 6 283 132
- JP-A- 56 153 656
- JP-A- 57 069 655
- US-A- 5 847 388
- US-A- 5 903 004
- LOWE B G ED - EDS : DAVID B WILLIAMS ET AL: "CHAPTER 2: Problems and Trends in X-Ray Detector Design for Microanalysis" 1. Januar 1995 (1995-01-01), X-RAY SPECTROMETRY IN ELECTRON BEAM INSTRUMENTS, PLENUM PRESS, PAGE(S) 7 - 19 , XP009136042 ISBN: 978-0-306-44858-4 das ganze Dokument

## Beschreibung

Die Erfindung betrifft einen Detektor zur gleichzeitigen, energiedispersiven Aufnahme von Rückstreuelektronen und Röntgenquanten, eine Vorrichtung zur gleichzeitigen, energiedispersiven Aufnahme von Rückstreuelektronen und Röntgenquanten und ein Verfahren zur gleichzeitigen energiedispersiven Messung von Rückstreuelektronen und Röntgenquanten.

### Stand der Technik

Es ist bekannt, zur Analyse von Proben in einem Rasterelektronenmikroskop (SEM) verschiedene Signale, die von der Probe abgegeben werden, heranzuziehen und auszuwerten. Zum einen ist es interessant, eine bildgebende Analyse zur Darstellung eines Bildes ähnlich dem Bild in einem Lichtmikroskop, aber mit zusätzlicher Information an jedem Punkt über die mittlere chemische Zusammensetzung, zu erhalten. Dazu eignet sich ein Rückstreuelektronen-Detektor. Zum anderen sind detailliertere Informationen über die in der Probe an dem Punkt enthaltenen Elemente mit deren Zusammensetzung interessant. Dies ist durch eine Elektronenstrahlmikroanalyse und die Detektion der in der Probe erzeugten Röntgenstrahlung möglich. Das Ausgabesignal ist dabei von der Ordnungszahl Z an der untersuchten Stelle der Probe abhängig. Man kann das Signal also zur Darstellung unterschiedlicher Zusammensetzungen der Probe an verschiedenen Stellen nutzen. Dieser Detektor wird somit zur bildgebenden Darstellung verwendet.

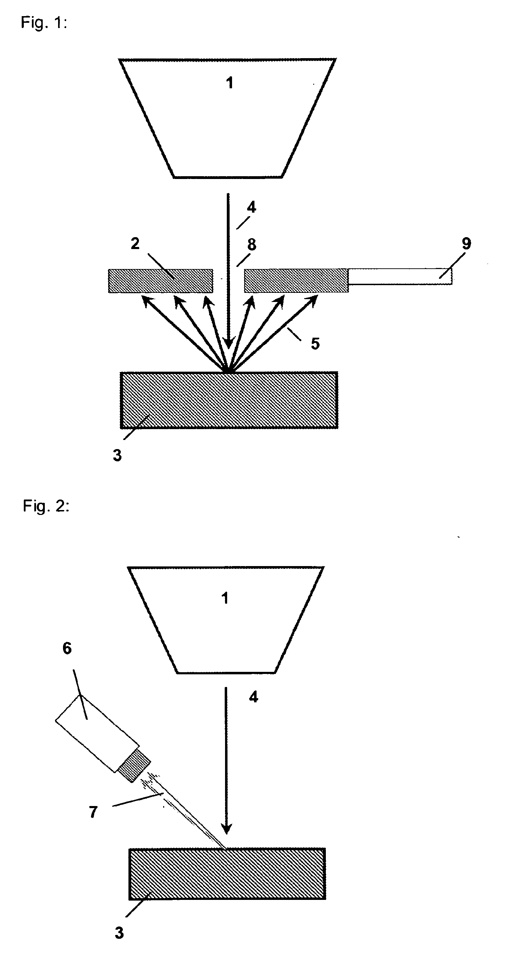

Der Rückstreuelektronen-Detektor (BSE-Detektor) 2, wie in Fig. 1 gezeigt ist ein flacher Halbleiter-Detektor, der eintretende Elektronen in Pulse umwandelt, somit nur die Anzahl der Elektronen messen kann. Es befindet sich zwischen der Primärelektronenquelle 1, dem Polschuh, aus dem die Elektronen 4 austreten, und der Probe 3. Dieser Detektor 2 hat einen großen Raumwinkel (Ω=0.5-2 sr) zur Erfassung hoher Intensität, hat aber keine Energieauflösung. Einzig eine energetische Schwelle, also Minimalenergie, kann genutzt werden, um Elektronen, die Energien bis zu einem bestimmten Wert haben, zu unterdrücken.

Dadurch, dass die BSE-Detektoren üblicherweise mehrere Segmente aufweisen (meist 2 oder 4), kann man durch Addition oder Subtraktion der Kanäle noch zusätzliche Information erhalten. Eine Addition ergibt einen Kompositionskontrast (Z-Kontrast), eine Subtraktion ergibt einen Topologiekontrast, gibt also die Oberflächenstruktur wieder.

Ferner kann ein Röntgen-Detektor zur Analyse der elementaren Zusammensetzung an der untersuchten Stelle der Probe genutzt werden. Bei diesem Detektor werden die Photonen, die in den Detektor-Kristall fallen, in einen Spannungspuls umgewandelt, an dessen Spannungswert man die Energie der Elektronen ermitteln kann, er ist somit ein energiedispersiver Detektor. Dieser Detektor ist nicht bildgebend, sondern liefert Spektren, mit denen man die Probe chemisch charakterisieren kann.

Fig. 2 zeigt einen Röntgendetektor 6 des Standes der Technik. Damit dieser Detektor 6 nur Röntgenquanten und keine BSE-Elektronen misst, wird standardmäßig eine Elektronenfalle vor den Detektor 6 gesetzt, der das Eintreten von Elektronen in den Detektor 6 verhindert. Gebräuchlich sind hierfür lithiumgedriftete Siliziumdetektoren, Si(Li), oder Siliziumdriftdetektoren, SDD.

Der Röntgendetektor ist, im Gegensatz zum BSE-Detektor relativ weit von der Probe entfernt und erfasst nur einen kleinen Raumwinkel, etwa Ω=0.01-0.1 sr, verglichen mit dem BSE-Detektor (Ω=0.5-2 sr). Bedingt durch die hinter dem Detektorkristall befindliche Elektronik zur Signalverarbeitung kann er nicht, wie der BSE-Detektor, zwischen Probe und Polschuh geschoben werden.

Eine Weiterentwicklung der BSE-Detektoren sind Inlens-Detektoren, die bei niedrigeren Anregungsenergien arbeiten und bei denen die Energieschwelle, ab der die Elektronen gemessen werden, genau eingestellt werden kann, durch ein Filterpotential am Gitter.

Ein anderer Ansatz, die Rückstreuelektronen energiedispersiv zu messen, ist der Einsatz eines energiedispersiven Elektronendetektors. Dieser Detektor hat eine Energieauflösung ΔE/E=0.04, einen kleinen Raumwinkel von ca. 0.02 (Öffnungswinkel 22°-18°=4°) und weder kommerziellen Aufbau noch Anwendungen. Es zeigt aber, dass Anwendungen bezüglich Schichtdickenanalysen möglich sind.

Problematisch ist jedoch, Röntgenstrahlen und Rückstreuelektronen mit einem Detektor gleichzeitig zu messen, da das Signalverhältnis Photonen zu BSE ungünstig ist.

GB-A-2295454 offenbart einen Detektor der dem Oberbegriff von Anspruch 1 entspricht.

### Zusammenfassung der Erfindung

Es ist daher Aufgabe der Erfindung, einen Detektor bereitzustellen, mit dem gleichzeitig Rückstreuelektronen und Röntgenquanten energieaufgelöst gemessen werden können.

Entsprechend wird ein Detektor zur gleichzeitigen energiedispersiven Aufnahme von Rückstreuelektronen und Röntgenstrahlung nach Anregung einer Probe mit Primärelektronen vorgeschlagen, umfassend: einen energiedispersives Röntgendetektorelement zur Detektion von Röntgenstrahlung und Rückstreuelektronen, und ein Mittel zur Reduktion des Beitrags der Rückstreuelektronen gegenüber dem Beitrag der Röntgenstrahlung vor dem Röntgendetektorelement angeordnet ist, und das Mittel derart ausgebildet ist, dass der Beitrag der Rückstreuelektronen gegenüber dem Beitrag der Röntgenstrahlung derart verringert wird, dass die charakteristischen Peaks der Röntgenstrahlung gegenüber dem Messsignal des Rückstreuelektronenbeitrags nachweisbar sind, und gleichzeitig nach Abzug des theoretischen Röntgenbremsstrahluntergrundes vom gemessenen Spektrum, ein Rückstreuelektronenbeitrag nachweisbar ist.

Das Mittel kann derart ausgebildet sein, dass mindestens eines der Merkmale gebildet aus der Gruppe der folgenden Merkmale zutrifft: die Anzahl der detektierten Rückstreuelektronen weist die gleiche Größenordnung auf wie die Anzahl der detektierten Röntgenphotonen; die Summe der Flächen unter den Röntgenpeaks weist die gleiche Größenordnung auf wie die Fläche des übrigen Untergrundbeitrags abzüglich des theoretischen Bremsstrahluntergrundes; die Anzahl der Pulse im Maximum des Röntgenpeaks ist mindestens das 1,5fache der Anzahl der Pulse des Untergrundbeitrags in der direkten Umgebung des Peaks oder mindestens das Doppelte oder mindestens das Fünffache.

Das Röntgendetektorelement kann ein ganzer Röntgendetektor sein oder bevorzugt lediglich das eigentliche Detektionselement oder der Detektionskristall des Röntgendetektors.

Die Bestimmung, ob Rückstreuelektronen im Spektrum vorhanden sind kann über eine bekannte Probe derart erfolgen, dass, wenn der Verlauf des Bremsstrahluntergrundes der Theorie entspricht, dann keine Rückstreuelektronen vorhanden sind. Unterscheidet sich der Verlauf von der Theorie, so sind Rückstreuelektronen vorhanden.

Der Detektor ist ausgerüstet mit einem Mittel zur Reduktion des Rückstreuelektronenanteils gegenüber dem Röntgenphotonenanteil, welches die Intensität der Röntgenstrahlung nicht nennenswert verringert, aber die Anzahl der von der Probe abgegebenen, wesentlich intensiveren BSE entsprechend verringert, so dass die Röntgenquanten und BSE gleichzeitig messbar sind. Da nämlich die Anzahl der von der Probe abgegebenen Rückstreuelektronen BSE um mehrere Größenordungen höher ist als die Anzahl der Röntgenphotonen, ist ohne ein spezielles Mittel zur Reduktion keine gleichzeitige Messung möglich, das Signalverhältnis Photonen zu BSE wäre zu ungünstig. Deshalb ist ein entsprechendes Mittel, bevorzugt eine Folie oder ein Fenster, notwendig, welches eine möglichst große Zahl von Photonen ungestört durchlässt und gleichzeitig die Anzahl der BSE so verringert, das die Anzahl beider Teilchenarten in der gleichen Größenordnung liegt.

Die entstehenden Röntgenquanten und Rückstreuelektronen können simultan erfasst und getrennt ausgewertet werden. Die beiden unterschiedlichen Spektrenanteile beeinflussen sich nicht signifikant, es ergibt sich also eine additive Überlagerung dieser Anteile. Deshalb ist es möglich, die Spektrenbeiträge bei bekannter genereller Form der beiden Spektren mit Hilfe eines Algorithmus zu trennen.

Vorteilhafterweise unterdrückt das Mittel zur Reduktion außerdem Sekundärelektronen SE, d.h. Elektronen niedriger Energie.

Die Energieauflösung für Photonen liegt im Bereich von 130eV für Mn-Kα.

Zusätzlich ist aber auch die Analyse des BSE-Spektrums möglich. Hier liegt die Energieauflösung ≤ 1 keV.

Das Mittel zur Reduktion kann derart ausgebildet sein, dass der Beitrag der Rückstreuelektronen gegenüber dem Beitrag der Röntgenstrahlung derart verringert wird, dass die charakteristischen Peaks der Röntgenstrahlung gegenüber dem Messsignal des Rückstreuelektronenbeitrags nachweisbar sind, und gleichzeitig nach Abzug des theoretischen Röntgenbremsstrahluntergrundes ein Rückstreuelektronenbeitrag gegenüber den Röntgenpeaks nachweisbar ist.

Das Mittel zur Reduktion kann derart ausgebildet sein, dass sich die Anzahl der detektierten Rückstreuelektronen von der Anzahl der detektierten Röntgenquanten um einen Faktor kleiner 100 unterscheidet, bevorzugt um einen Faktor kleiner 50, noch bevorzugter um einen Faktor kleiner 10.

Das Mittel kann derart ausgebildet sein, dass sich die Summen der Flächen unter den Röntgenpeaks von der Fläche des übrigen Beitrags um einen Faktor kleiner 100 unterscheidet, bevorzugt um einen Faktor kleiner 50, noch bevorzugter um einen Faktor kleiner 10.

Der Detektor kann in seinem Zentrum ein Loch zum Durchlass von Primärelektronen enthalten. Daher kann er vorteilhafterweise direkt in den Elektronenstrahlgang zwischen Primärelektronenquelle und Probe angeordnet werden.

Der Detektor kann in mehrere Sektoren unterteilt sein, bevorzugt in vier Sektoren. Diese können wie beim konventionellen BSE-Detektor zur Analyse mit Kompositions- und Topologiekontrast verwendet werden. Bei niedriger Anregungsenergie lässt sich ein nur durch Röntgenstrahlung generiertes Spektrum ohne BSE-Beiträge messen. Durch unterschiedliche Fenster für verschiedene Sektoren lassen sich für eine angepasste Anregungsenergie somit Spektren mit und ohne BSE-Beitrag gleichzeitig messen, so dass die Auswertung der unterschiedlichen Signale dadurch vereinfacht werden kann.

Das Röntgendetektorelement kann ein Halbleiterdetektor und/oder ein Silizium-Drift-Detektor sein.

Der Detektor kann derart ausgebildet sein, dass er einen Raumwinkel von 0,5 - 2 sr erfasst.

Es ist mit dem erfindungsgemäßen Detektor nicht nur eine qualitative, sondern auch eine quantitative Analyse des Spektrenteils, der durch Photonen erzeugt wird, möglich und man erhält die analytische Aussagekraft wie bei einem konventionellen Röntgendetektor mit dem zusätzlichen Vorteil eines großen Raumwinkels.

Das Mittel zur Reduktion kann aus Polymeren bestehen und/oder aus einem der Elemente aus der Gruppe gebildet aus Polyethylenterephthalat und Poly(p-xylylen).

Das Mittel zur Reduktion ist bevorzugt eine Folie, die auf der Eingangseite des Röntgendetektorelementes angeordnet ist. Für eine Anregungsenergie von Primärelektronen kleiner 10 keV kann die Foliendicke weniger als 3 µm betragen, bevorzugt 1,5-2,5 µm. Für eine Anregungsenergie von Primärelektronen von größer gleich 10 keV und kleiner 15 keV kann die Foliendicke 3-5 µm betragen, bevorzugt 3,5-4,5 µm. Für Anregungsenergien von Primärelektronen von größer gleich 15 keV bis kleiner 25 keV kann die Foliendicke 5-9 µm betragen, bevorzugt 7,5-8,5 µm.

Entsprechend ist eine Vorrichtung zur Simultanen Messung von Röntgenstrahlen und Rückstreuelektronen angegeben, umfassend eine Primärelektronenstrahlquelle; einen Probenhalter, angeordnet im Emissionsbereich der Elektronenstrahlquelle; einen erfindungsgemäßen Detektor, angeordnet im Elektronenstrahlgang zwischen Primärelektronenstrahlquelle und Probenhalter, und ein Mittel zur Auswertung der Messdaten.

Der Abstand zwischen Probehalter und Detektor kann im Bereich von 2 bis 40 mm liegen.

Ferner ist ein Verfahren zur gleichzeitigen Messung und Auswertung von Rückstreuelektronen und Röntgenstrahlung mit einer erfindungsgemäßen Vorrichtung vorgeschlagen, umfassend die Schritte: Bestrahlung einer Probe mit Primärelektronen; Rückstreuung von Elektronen von der Probe auf den Detektor und gleichzeitige Bestrahlung des Detektors mit Röntgenstrahlung von der Probe, wobei der Beitrag der Rückstreuelektronen vor dem Röntgendetektorelement derart reduziert wird, dass mindestens eines der Merkmale gebildet aus der Gruppe der folgenden Merkmale zutrifft: die Anzahl der detektierten Rückstreuelektronen weist die gleiche Größenordnung auf wie die Anzahl der detektierten Röntgenphotonen; die Summe der Flächen unter den Röntgenpeaks weist die gleiche Größenordnung auf wie die Fläche des Untergrundbeitrags abzüglich des theoretischen Bremsstrahluntergrundes; die Pulsenergie eines Röntgenpeaks in Elektronenvolt ist mindestens das 1,5fache der Pulsenergie des Untergrundbeitrags in der direkten Umgebung des Peaks oder mindestens das Doppelte oder mindestens das Fünffache.

Der Beitrag der Rückstreuelektronen gegenüber dem Beitrag der Röntgenstrahlung kann derart verringert werden, dass die charakteristischen Peaks der Röntgenstrahlung gegenüber dem Messsignal des Rückstreuelektronenbeitrags nachweisbar sind, und gleichzeitig nach Abzug des theoretischen Röntgenbremsstrahluntergrundes ein Rückstreuelektronenbeitrag gegenüber den Röntgenpeaks nachweisbar ist.

Zur Auswertung der Messdaten kann der theoretisch berechnete Röntgenbremsstrahluntergrund von den energieaufgelösten Messdaten abgezogen werden.

Die Subtraktion kann im Bereich des asymptotischen Abfalls der theoretisch berechnete Röntgenbremsstrahluntergrund vorgenommen werden und aus den erhaltenen Daten kann durch Auswertung der Spektren an jedem Punkt der Oberfläche ein Mapping erstellt werden, indem der Flächengröße bzw. der Countzahl ein Grauwert oder Farbwert zugeordnet wird.

Grundsätzlich würde eine Analyse der Gesamtzahl der Elektronen im Spektrum einer Analyse im konventionellen BSE-Detektor gleichkommen. Die Auflösung der BSE-Energie ermöglicht die Selektion der Elektronen nach verschiedenen Energien und damit aus verschiedenen Ausdringtiefen, d.h. die Analyse ist tiefensensitiv. Dadurch kann man z.B. Schichtsysteme untersuchen. Da außerdem das Wechselwirkungsvolumen mit größerer Tiefe zunimmt und auch das Wechselwirkungsvolumen, aus dem die Photonen stammen, groß ist, ist durch die Auswertung von Rückstreuelektronen niedriger Energie die laterale Auflösung höher als bei der Auswertung aller Rückstreuelektronen oder der Auswertung von Photonen.

Durch verschiedene Sektoren ist außerdem der Kompositions- und Topologiekontrast messbar. Zusätzliche Informationen kann man durch Kombination der Segmentsignale mit der Unterscheidung der Elektronenintensität für unterschiedliche Energien erhalten.

### Kurze Beschreibung der Figuren

Die Erfindung wird im Folgenden anhand einiger Figuren beispielhaft aber nicht beschränkend beschreiben. Es zeigt:
- Fig. 1: eine Vorrichtung zur Messung von Rückstreuelektronen des Standes der Technik;
- Fig. 2: eine Vorrichtung zur energieaufgelösten Messung von Röntgenstrahlung des Standes der Technik;
- Fig. 3: eine erfindungsgemäße Vorrichtung zur gleichzeitigen energieaufgelösten Messung von Rückstreuelektronen und Röntgenstrahlung;
- Fig. 4, 5: den mit der Vorrichtung der Fig. 3 gemessenen Zählimpuls in Abhängigkeit von der Energie in einem ersten Beispiel bei 12 keV (Fig. 4) und 15 keV (Fig. 5) Anregungsenergie;
- Fig. 6, 7: den mit der Vorrichtung der Fig. 3 gemessenen Zählimpuls in Abhängigkeit von der Energie in einem zweiten Beispiel bei 12 keV (Fig. 6) und 15 keV (Fig. 7) Anregungsenergie;
- Fig. 8: die Abhängigkeit des mit der Vorrichtung der Fig. 3 gemessenen Spektrums für Proben mit Z=13, Z=51, und Z=83 als Pulshöhe in Abhängigkeit von der Energie;
- Fig. 9: zwei Spektren eines erfindungsgemäßen Detektors für eine Mn-Probe, einmal mit zu dünner Folie (schwarz) und einmal mit zu dicker Folie (grau);
- Fig. 10: drei erfindungsgemäße Spektren einer Probe aus CuO, NiP und Sn-haltigen Lotkugeln auf einer C-Schicht;
- Fig. 11: bildgebendes Mapping Bild der Spektren der Probe aus Fig. 10;
- Fig. 12a-c: bildgebendes Mapping der Spektren der Probe aus Fig. 10, aufgeteilt nach den jeweiligen Teilintensitäten für Cu-L (Fig. 12a), Ni-L (Fig. 12b), und Sn-L (Fig. 12c) der entsprechenden Anteile;
- Fig. 13: gemessenes Spektrum mit wesentlichem Teil Röntgen- und Rückstreuelektronenbeitrag des Spektrums der Fig. 10 (schwarz) und theoretisch berechneter Bremsstrahluntergrund (grau);
- Fig. 14:: bildgebendes Mapping des Spektrums der Fig. 13 (schwarz) nach Abzug des theoretisch berechneten Bremsstrahluntergrunds aus Fig. 13.

### Detaillierte Beschreibung der Figuren

Figur 1 und 2 zeigen einen Rückstreuelektronendetektor 2 und einen Röntgendetektor 6 des Standes der Technik, wie bereits einleitend beschrieben. Der Röntgendetektor 6 kann dabei energiedispersiv messen. Es ist aus dem Stand der Technik bekannt, dass energiedispersive Detektoren Untergrund und Peaks gleichzeitig aufzeichnen. Die Teilchen mit einer kontinuierlichen Energieverteilung werden dabei in Kanäle, die einen bestimmten Energiebereich haben, einsortiert. Man erhält ein Spektrum, in dem verschiedene Countzahlen oder Anzahl der Impulse in verschiedene Kanäle aufgenommen werden. Die Kanäle haben eine bestimmte Breite, typischerweise 5eV, d.h. Kanal 1 zählt alle Teilchen mit einer Energie von 0-5eV, Kanal 2 alle mit 5<=E<10eV_{,} Kanal 100 alle mit 500<=E<505eV. Dabei ist ein Peak in einem Spektrum "nachweisbar", wenn er sich vom Untergrund trennen lässt. Bekanntermaßen kann für die Nachweisbarkeitsgrenze ein linearer Untergrund unter dem Peak konstruiert werden. Dieser kann bestimmt werden, indem man an der hoch- und niederenergetischen Seite des Peaks jeweils einen Punkt festlegt, der mindestens die zweifache Halbwertsbreite des Peaks vom Zentralkanal entfernt ist und visuell im Untergrund liegt und diese beiden Punkte durch eine Gerade miteinander verbindet. Die Peakintensität P ist die Summe aller Counts im Peakbereich oberhalb dieser Linie. Der Untergrundwert U ist die Anzahl der Counts unterhalb der Linie, aber nur in dem einen Zentralkanal unterhalb des Peaks. Ein Peak liegt dann oberhalb der Nachweisbarkeitsgrenze, wenn P >= 3 * √ (U), oder in Worten, wenn die Peakfläche größer oder gleich ist dem dreifachen Wert der Quadratwurzel aus der Untergrundintensität unter dem Peak.

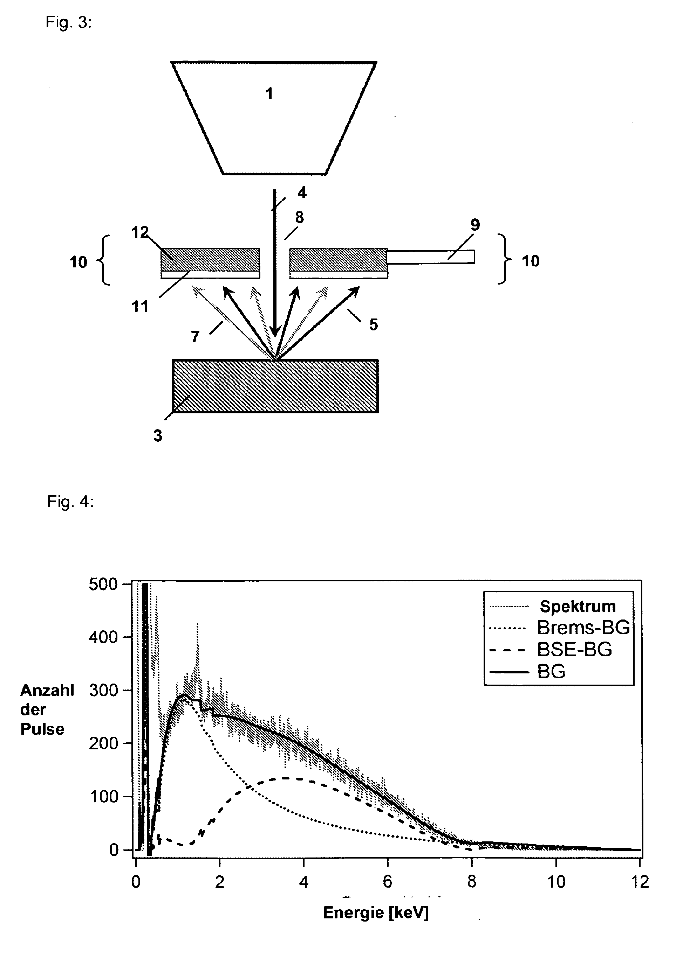

Figur 3 zeigt eine erfindungsgemäße Vorrichtung zur gleichzeitigen energieaufgelösten Messung von Rückstreuelektronen und Röntgenstrahlung.

Die Implementierung besteht aus dem Detektor 10 wie in Fig. 3 gezeigt, der einen konventionelles energiedispersives Röntgendetektorelement 12 umfasst, vor dem eingangsseitig ein Mittel (11) zur Reduktion des Beitrags der Rückstreuelektronen gegenüber dem Beitrag der Röntgenstrahlung angeordnet ist, sowie einer geeigneten Software, die Spektren erfassen und ggf. die Anteile der Photonen und BSE separieren und getrennt auswerten kann.

Das energiedispersive Röntgendetektorelement 12 ist ein Element aus einem Material, wie es zur eigentlichen Detektion von Röntgenstrahlung in einem Röntgendetektor verwendet wird. Bevorzugt handelt es sich um Halbleiterdetektorelement 12, noch bevorzugter um ein Element 12, wie es in einem Siliziumdriftdetektor verwendet wird, bestehend aus Silizium oder Si(Li).

Ein Siliziumdriftdetektor kann dabei nicht nur Röntgenstrahlung detektieren, sonder auch ionisierende Teilchen wie Elektronen. Durch die einfallende ionisierende Strahlung werden im Halbleiter Elektronen angeregt. Ein Röntgenquant, das in das Halbleitermaterial eindringt, kann mit seiner Energie aufgrund des Photoeffekts ein Elektron des Valenz- in einen unbesetzten Zustand des Leitungsbandes des Halbleiters heben. Im Valenzband bleibt dann ein Loch zurück. Das ausgelöste Elektron regt weitere Elektronen an, und es entstehen weitere Elektronen-Loch-Paare, die aufgrund eines elektrischen Feldes zu den Elektroden wandern. Auch ein eindringendes Elektron erzeugt im Halbleiter Elektron-Loch-Paare entlang seiner Bahn, welche wiederum weitere Elektronen-Loch-Paare erzeugen.

Das erfindungsgemäße Röntgendetektorelement 12 ist im Detektor 10 gegenüber einem herkömmlichen Röntgendetektor 6 flacher und mit einer größeren Fläche angeordnet. Die Höhe des Röntgendetektorelements 12 beträgt zwischen 1 und 5 mm und seine Fläche variiert zwischen 10 mm² und 120 mm², bevorzugt zwischen 30 mm² und 90 mm², noch bevorzugter zwischen 50 mm² und 70 mm². Bevorzugt handelt es sich um einen flachen Detektorkristall, bei dem seitlich die Elektronik- und Signalverarbeitung 9 angeordnet ist. Das Röntgendetektorelement 12 ist derart ausgebildet, dass eine Raumwinkel von Ω=0,5-2sr erfasst wird. Das Röntgendetektorelement 12 kann dabei aus mehreren Teilsektoren bestehen, die wiederum eine rechteckige Form oder die Form eines Kreiselementes haben können.

Der Detektor 10 mit dem Röntgendetektorelement 12 ist derart ausgebildet, dass er im Vergleich zu einem herkömmlichen Röntgendetektor 6 direkt im Elektronenstrahlgang 4 zwischen Primärelektronenquelle 1 und Probe 3 anordbar ist. Dies wird dadurch realisiert, dass der Detektor 10 ein Loch 8 aufweist, welches bevorzugt mittig im Detektor 10 angeordnet ist, durch dass die Primärelektronen 4 den Detektor 10 durchschreiten und die Probe 3 erreichen können. Von der Probe 3 werden dann die Elektronen 5 rückgestreut und es wird gleichzeitig Röntgenstrahlung 7 erzeugt. Eine Seite des Detektors 10 ist bevorzugt der Primärelektronenquelle 1 zugewandt angeordnet, die andere Seite ist der Probe 3 zugewandt angeordnet. Bevorzugt ist die der Primärelektronenquelle 1 zugewandte Seite und die abgewandte Seite orthogonal zum Primärelektronenstrahl 4 angeordnet.

Ein erfindungsgemäßer Detektor 10 ist im Vergleich zu einem herkömmlichen Röntgendetektor 6 der Fig. 2 näher an der Probe 3 angeordnet. Der Abstand Probe 3 zum Detektor 5 beträgt weniger als 40 mm, bevorzugt weniger als 10 mm.

Auf der Eingangsseite des energiedispersiven Röntgendetektorelements 12 ist dabei das Mittel 11 zur Reduktion des Beitrages der Rückstreuelektronen 5 gegenüber dem Beitrag der Röntgenstrahlung 7 angeordnet. Das Mittel 11 bedeckt dabei bevorzugt die Eingangsseite des energiedispersiven Röntgendetektorelementes 12 vollständig. Mit anderen Worten, die auf den Detektor 10 einfallende Röntgenstrahlung 7 und die einfallenden Rückstreuelektronen 5 müssen zunächst das Mittel 11 passieren, bevor sie auf das eigentliche Detektorelement 12 zur Detektion von Röntgenstrahlung 7 und Elektronen 5 treffen. Das Mittel 11 reduziert dabei die Zahl der Rückstreuelektronen 5, die auf das energiedispersive Röntgendetektorelement 12 auftreffen stärker als die Zahl der Röntgenquanten 7, sodass der Anteil der Rückstreuelektronen 5 gegenüber dem Anteil der Röntgenquanten 7 in der Gesamteingangsstrahlung, die auf das Röntgendetektorelement 12 einfällt, verringert wird.

Mit anderen Worten, der Detektor 10 ist ausgerüstet mit einem Mittel 11, das die Intensität der Röntgenstrahlung 7 nicht nennenswert verringert, aber die Anzahl der von der Probe abgegebenen, wesentlich intensiveren BSE 5 entsprechend verringert, so dass Röntgenquanten und BSE gleichzeitig messbar sind. Das Mittel 11 unterdrückt außerdem Sekundärelektronen (SE), d.h. Elektronen niedriger Energie.

Durch die Wahl der Anregungsenergie oder des Mittels 11 kann man eine vergleichbare Anzahl von Photonen und BSE im Spektrum erhalten. Die beiden unterschiedlichen Spektrenanteile beeinflussen sich nicht signifikant, es ergibt sich also eine additive Überlagerung dieser Anteile. Deshalb ist es möglich, die Spektrenbeiträge bei bekannter genereller Form der beiden Spektren mit Hilfe eines Algorithmus zu trennen.

Bevorzugt ist das Mittel 11 zur Reduktion des Beitrags der Rückstreuelektronen 5 gegenüber dem Beitrag der Röntgenstrahlung 7 als eine Folie ausgebildet. Im Folgenden wird daher zur Abkürzung der Beschreibung das Wort "Folie" anstatt des Terms "Mittel 11 zur Reduktion des Beitrags der Rückstreuelektronen 5 gegenüber dem Beitrag der Röntgenstrahlung 7" verwendet werden. Diese Begriffe sind im Folgenden austauschbar.

Die Folie 11 wird bevorzugt mit einer Halterung (nicht gezeigt) vor der Eingangsseite des energiedispersiven Röntgendetektorelements 12 angeordnet. Noch bevorzugter ist die Folie 11 austauschbar angeordnet.

Die Folie 11 muss dabei gewisse Kriterien erfüllen, damit Rückstreuelektronen 5 und Röntgenquanten 7 gleichzeitig messbar sind. Die Folie 11 ist derart ausgebildet ist, dass:
der Beitrag der Rückstreuelektronen 5 gegenüber dem Beitrag der Röntgenstrahlung 7 derart verringert wird, dass die charakteristischen Peaks der Röntgenstrahlung 7 gegenüber dem Messsignal des Rückstreuelektronenbeitrags 5 nachweisbar sind, und gleichzeitig
nach Abzug des theoretischen Röntgenbremsstrahluntergrundes vom gemessenen Spektrum, ein Rückstreuelektronenbeitrag nachweisbar ist.

Ferner kann das Mittel 11 derart ausgebildet ist, dass mindestens eines der Merkmale gebildet aus der Gruppe der folgenden Merkmale zutrifft:
die Anzahl der detektierten Rückstreuelektronen 5 weist die gleiche Größenordnung auf wie die Anzahl der detektierten Röntgenphotonen 7;
die Summe der Flächen unter den Röntgenpeaks weist die gleiche Größenordnung auf wie die Fläche des übrigen Untergrundbeitrags abzüglich des theoretischen Bremsstrahluntergrundes;
die Anzahl der Pulse im Maximum des Röntgenpeaks ist mindestens das 1,5fache der Anzahl der Pulse des Untergrundbeitrags des Peaks oder mindestens das Doppelte oder mindestens das Fünffache.

Die obigen Kriterien sind dabei als äquivalent zu werten. Sie definieren die Folie dadurch, dass sowohl Röntgenquanten als auch Rückstreuelektronen messbar sind. Es kann nur eines von ihnen erfüllt sein oder es können zwei von ihnen erfüllt sein bevorzugt sind alle Kriterien gleichzeitig erfüllt.

Der Detektor dient also nicht allein der Messung von Röntgenquanten oder der Messung vor Rückstreuelektronen, sondern misst beide Anteile.

Ein weiteres Merkmal der Folie 11 ist es, dass der Beitrag der Rückstreuelektronen 5 gegenüber dem Beitrag der Röntgenstrahlung 7 derart verringert wird, dass die charakteristischen Peaks der Röntgenstrahlung 7 gegenüber dem Messsignal des Rückstreuelektronenbeitrags 5 nachweisbar sind, und gleichzeitig nach Abzug des theoretischen Röntgenbremsstrahluntergrundes ein Rückstreuelektronenbeitrag gegenüber den Röntgenpeaks nachweisbar ist. Letzterer Rückstreuelektronenbeitrag ist dabei in den Spektren besonders dort zu erkennen, wo der theoretische Röntgenbremsstrahluntergrund asymptotisch abfällt. Ist im Bereich des asymptotischen Abfalls des theoretisch berechneten Röntgenbremsstrahluntergrundes ein Unterschied zum theoretisch berechneten Röntgenbremsstrahluntergrund im Spektrum nachweisbar, so sind Beiträge von Rückstreuelektronen vorhanden.

Die Folie 11 wird erfindungsgemäß in Abhängigkeit von der verwendeten Anregungsenergie der Primärelektronen 4 ausgewählt. Die Erfüllung obiger Kriterien je nach Anregungsenergie kann dann durch entsprechende Wahl des Folienmaterials und/oder der Foliendicke geschehen.

Der Detektor kann Röntgenquanten mit der Auflösung eines guten Röntgendetektors und einer sehr hohen Zählrate verarbeiten und ein übliches Spektrum darstellen. Die Zählrate kann dabei bis zu 10⁶ Ereignisse pro Sekunde betragen.

Der Detektor 10 kann aus mehreren Detektorsektoren bestehen, die separat voneinander messen können. So kann die Gesamtfläche eines Detektors 10 kreisförmig sein, wobei die Detektorsegmente als Kreiselemente um das Loch 8 in der Mitte des Detektors 10 angeordnet sein können. Die Detektorsegmente können aber auch rechteckig oder quadratisch sein. Die Sektoren können wie beim konventionellen BSE-Detektor 2 zur Analyse mit Kompositions- und Topologiekontrast verwendet werden. Zusätzliche Informationen kann man durch Kombination der Segmentsignale mit der Unterscheidung der Elektronenintensität für unterschiedliche Energien erhalten. Wenn der Detektor 10 mehrere Segmente aufweist, meist 2 oder 4, kann man durch Addition oder Subtraktion der Kanäle noch zusätzliche Information erhalten: Addition ergibt einen Kompositionskontrast (Z-Kontrast), Subtraktion ergibt einen Topologiekontrast, gibt also die Oberflächenstruktur wieder.

Als Materialien für die Folie 11 können Polymere, z.B. Polyethylenterephthalat PET [C₁₀H₈O₄]ₙ (beispielsweise unter dem Markenname Mylar® vertrieben) oder Poly(p-xylylen) [C₈H₈]ₙ (beispielsweise unter dem Markenname Parylene N® vertrieben), benutzt werden. Im Folgenden beziehen sich alle gezeigte Anwendungen und Experimente auf Folien 11, die aus Mylar® bestehen.

Zur Nutzung verschiedener Primärenergien können Folien 11 verschiedener Dicke, 1 µm, 2 µm, 3 µm und 6 µm, eingesetzt werden, um für diese Energien einen vergleichbaren Beitrag durch Röntgenquanten und BSE zu erzielen.

Beispiele für die Foliendicken sind 2 µm bei einer Anregungsenergie von kleiner 10 keV, 4 µm bei einer Anregungsenergie von kleiner 15 keV aber größer 10 keV und 8 µm bei einer Anregungsenergie von kleiner 25 keV aber größer 15 keV. Die angegebenen Dicken können bevorzugt um 0,5 µm nach oben und unten variieren.

Gleichzeitig unterdrücken alle diese Fenster einen Beitrag durch niederenergetische Sekundärelektronen, die andere Energie- und Z-Abhängigkeiten sowie Kontraste liefern.

Bei niedriger Anregungsenergie oder hoher Foliendicke lässt sich ein nur durch Röntgenstrahlung 7 generiertes Spektrum ohne BSE-Beiträge 5 messen. Durch unterschiedliche Folien 11 für verschiedene Sektoren des Detektors lassen sich für eine angepasste Anregungsenergie somit Spektren mit und ohne BSE-Beitrag gleichzeitig messen, so dass die Auswertung der unterschiedlichen Signale dadurch vereinfacht werden kann.

In beiden Fällen ist nicht nur eine qualitative, sondern auch eine quantitative Analyse des Spektrenteils, der durch Photonen erzeugt wird, möglich und man erhält die analytische Aussagekraft wie bei einem konventionellen, energieaufgelösten Röntgendetektor mit dem zusätzlichen Vorteil eines großen Raumwinkels.

Die Energieauflösung für Photonen liegt bevorzugt im Bereich von 130 eV für Mn-Kα.

Zusätzlich ist aber auch die Analyse des BSE-Spektrums möglich. Hier liegt die Energieauflösung bei ≤ 1 keV.

Eine Analyse der Gesamtzahl der Elektronen 5 im Spektrum würde einer Analyse im konventionellen BSE-Detektor 2 gleichkommen. Die Auflösung der BSE-Energie ermöglicht die Selektion der Elektronen 5 nach verschiedenen Energien und damit aus verschiedenen Ausdringtiefen, d.h. die Analyse ist tiefensensitiv. Dadurch kann man vorteilhaft z.B. Schichtsysteme untersuchen. Da außerdem das Wechselwirkungsvolumen mit größerer Tiefe zunimmt und auch das Wechselwirkungsvolumen, aus dem die Photonen stammen, groß ist, ist durch die Auswertung von Rückstreuelektronen 5 niedriger Energie die laterale Auflösung höher als bei der Auswertung aller Rückstreuelektronen 5 oder der Auswertung von Photonen.

Bei Anregungsenergien, die einen Elektronenbeitrag im Spektrum verhindern, sind mithilfe dieses Detektors 10 aufgrund des großen erfassten Raumwinkels, ein Mapping des Photonensignals wie bei einem konventionellen Röntgendetektor 6 möglich, allerdings mit hoher Geschwindigkeit. Der große Raumwinkel sorgt auch für eine geringere Abschattung. Dies ist sonst nur durch mehrere Messungen mit gedrehter Probe möglich.

Es werden im Folgenden einige Anwendungsbeispiele einer Messung mit einem erfindungsgemäßen Detektor 10 bzw. einer entsprechenden Vorrichtung der Fig. 3 vorgestellt.

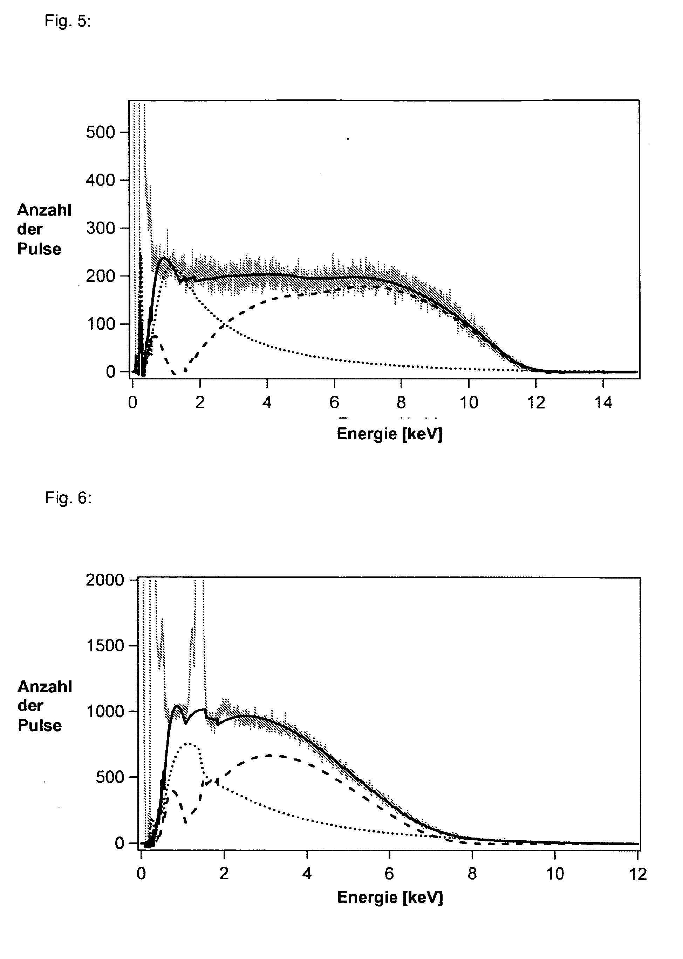

Bei Anregungsenergien, die einen Elektronen- und Photonenbeitrag liefern, sieht das Spektrum wie in Fig. 4 und Fig. 5 für Kohlenstoff mit Z=6 gezeigt aus, wobei der Zählimpuls in Abhängigkeit von der Energie dargestellt ist. Die Figuren 4 und 5 von Kohlenstoff (Z=6), gemessen bei einer Anregungsenergie von 12 und 15 keV zeigen das gemessene Spektrum (grau), einen gefitteten Untergrundverlauf (BG, schwarz), sowie die Zusammensetzung des Untergrundes aus einem Anteil, der durch Photonen entsteht (Brems-BG, gepunktet, schwarz) und einem Anteil, der durch Rückstreuelektronen entsteht (BSE-BG, gestrichelt, schwarz). Man sieht, das BSE- und Photonen-Beitrag für jeden Teil der Figuren einen charakteristischen Energieverlauf haben, der vollkommen unterschiedlich ist. Zusätzlich ist die Energieabhängigkeit der BSE zu sehen.

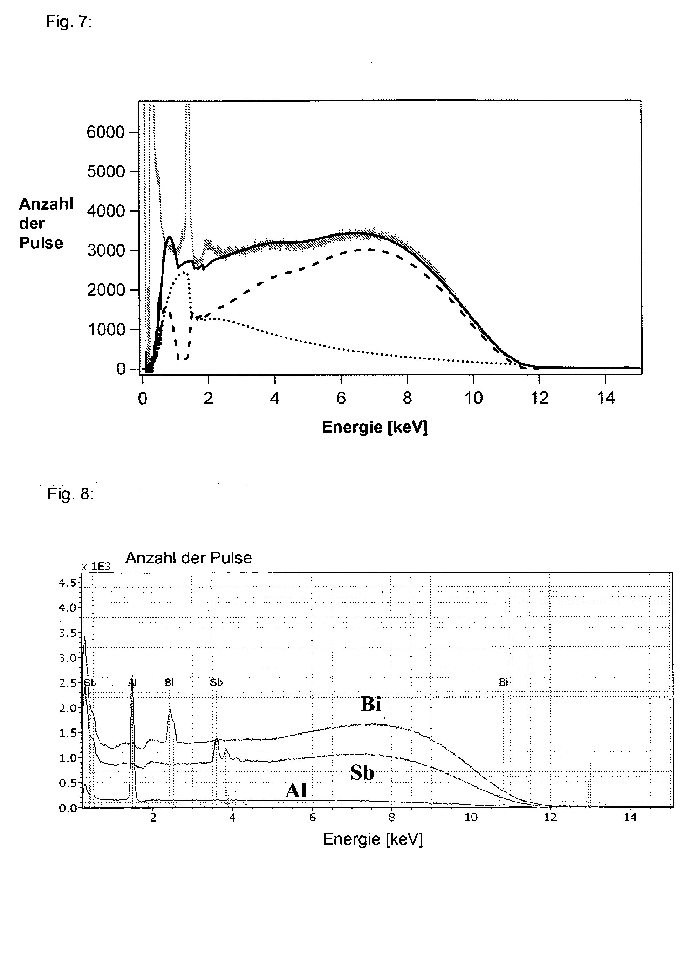

Für Selen (Z=34) ergeben sich bei 12 keV bzw. 15 keV die in Fig. 6 und Fig. 7 gezeigten Spektren. Hier ist ebenfalls der charakteristische Energieverlauf für beide Teile sichtbar. Darüber hinaus ist im Vergleich zu Fig. 4 und 5 auch eine Abhängigkeit von der mittleren Ordnungszahl Z zu sehen.

Ferner zeigt Fig. 8 die Elektronen im Untergrund bei 15 keV für Z=13, Z=51, und Z=83.

Es zeigt sich eine Abhängigkeit der Gesamtintensität des Elektronenbeitrags von der Ordnungszahl Z, wie er zur Abbildung bei BSE-Detektoren genutzt wird, besonders im Bereich 5-10 keV. Darüber hinaus zeigt sich aber auch ein unterschiedlicher Verlauf, d.h. eine Energieabhängigkeit der BSE für verschiedene Z, besonders stark im Bereich 7-9 keV, verglichen mit der Energieabhängigkeit bei 5-6 keV. Dieses energieaufgelöste BSE-Signal kann zusätzlich zum Röntgensignal zur Auswertung herangezogen werden.

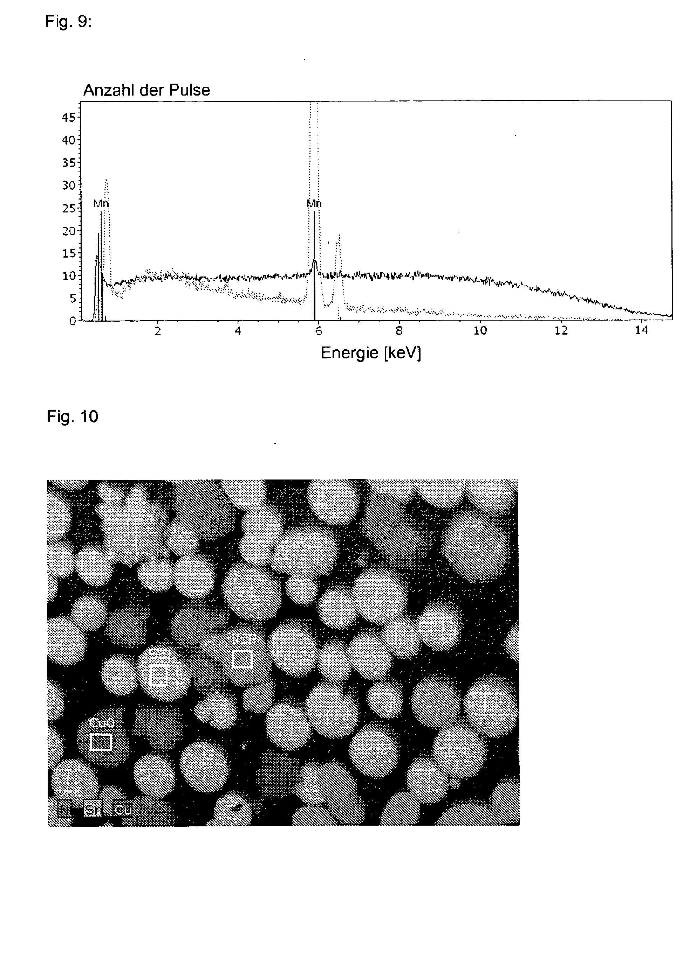

Fig. 9 zeigt ein Spektren für eine reine Manganprobe, die entstehen, wenn die Folie 11 zu dick (grau) oder zu dünn (schwarz) gewählt wird. Die Dicken der Folien betragen 6 µm bzw. 3 µm bei einer Anregungsenergie von 18 keV und bestehen aus Mylar®. Bei zu dicker Folie 11 wird der Anteil der Rückstreuelektronen 5 vollständig unterdrückt und es entsteht ein reines Röntgenspektrum (grau). Wird eine zu dünne Folie gewählt, so entsteht ein Spektrum (schwarz), in dem der Anteil an Rückstreuelektronen 5 so hoch wird, dass die charakteristischen Peaks der Röntgenstrahlung so klein werden, dass sie im Bereich des Rauschens des BSE-Signals liegen und nicht mehr ausgewertet werden können. Bei einer noch dünneren Folie 11 sind die Peaks gar nicht mehr nachweisbar. Zusätzlich wird durch eine zu dünne Folie 11 oder Weglassen der Folie 11 die Pulslast durch die große Anzahl an Rückstreuelektronen 5 zu hoch, so dass der Detektor 10 keine Pulse mehr verarbeiten kann. Wie man erkennt, unterscheiden sich die Spektren einmal dadurch, dass Röntgenpeaks überhaupt sichtbar bzw. nachweisbar sind und andererseits, dass im höheren Energiebereich ab 3eV, bei dem die Röntgenbremsstrahlung asymptotisch abfällt, ähnlich wie in Fig. 4 gezeigt, ein Rückstreuelektronenanteil sichtbar ist.

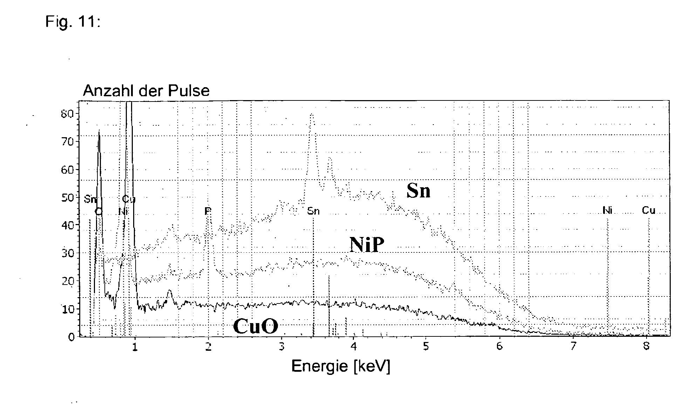

Fig. 10 und 11 zeigen ein Anwendungsbeispiel, bei dem Lotkugeln mit den Phasen CuO, NiP, Sn bei einer Energie von HV=9kV auf einer Kohlenstoffoberfläche angeordnet sind. Die verwendete Dicke der Folie 11 beträgt 2 µm. Die Folie 11 besteht, wie bereits erwähnt, aus Mylar®.

Drei gleich große Bereiche der CuO- (dunkelgrau, kleines Z), NiP- (grau, mittleres Z) und Sn-Phase (hellgrau, großes Z) der Fig. 10 liefern Summenspektren der Fig. 11 mit deutlich zu erkennenden, von der Ordnungszahl Z abhängenden, BSE-Untergrundbeiträgen.

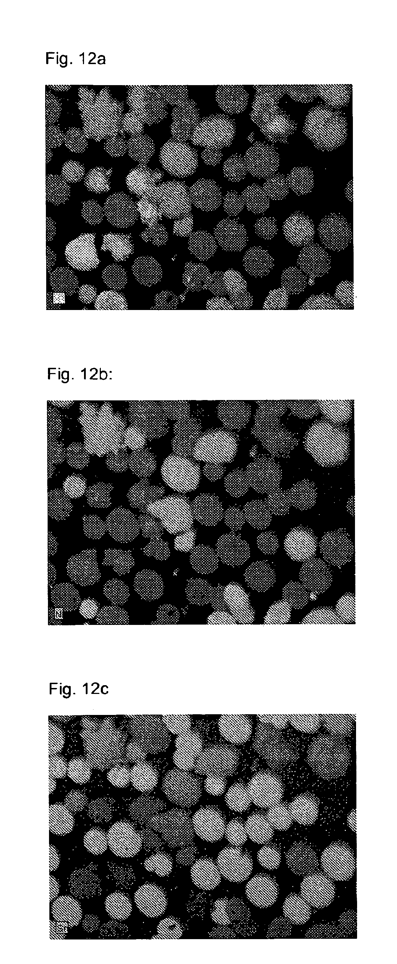

Das Mapping, bei denen die Cu-L-, Ni-L-, Sn-L-Intensitäten in einen Graustufenwert umgesetzt wurden, ergibt Grafiken wie in Figuren 12a-c gezeigt.

Stand der Technik für das Mapping der Spektren ist folgendes Vorgehen: der Elektronenstrahl wird zeilenförmig über ein Probengebiet geführt und an jeder Stelle ein Spektrum aufgenommen. Dies wird ausgewertet, z.B. nach prozentualem Cu, Ni, Sn-Gehalt oder nach Fläche der untergrundkorrigierten Peaks. Dann wird jedem Punkt, an dem das Spektrum gemessen wurde, eine Helligkeit in einer Farbe zugeordnet, man erhält also ein Falschfarbenbild.

Neu an der erfindungsgemäßen Auswertung ist, dass man zusätzlich noch den BSE-Anteil in jedem Spektrum auswerten kann, der (qualitativ) Auskunft über die mittlere Ordnungszahl gibt. Auch hier kann man wieder die Fläche des untergrundkorrigierten Bereichs nehmen, man kann also Peakflächen mit BSE-Bereichsflächen (oder Countzahlen) vergleichen.

Dies könnte man als zusätzliche Farbe mit in das Mapping aufnehmen, wurde in Fig. 12a-c allerdings ausgeblendet, um deutlich zu machen, dass sich ein Mapping ergibt, wie es von einem BSE-Detektor erhalten werden kann.

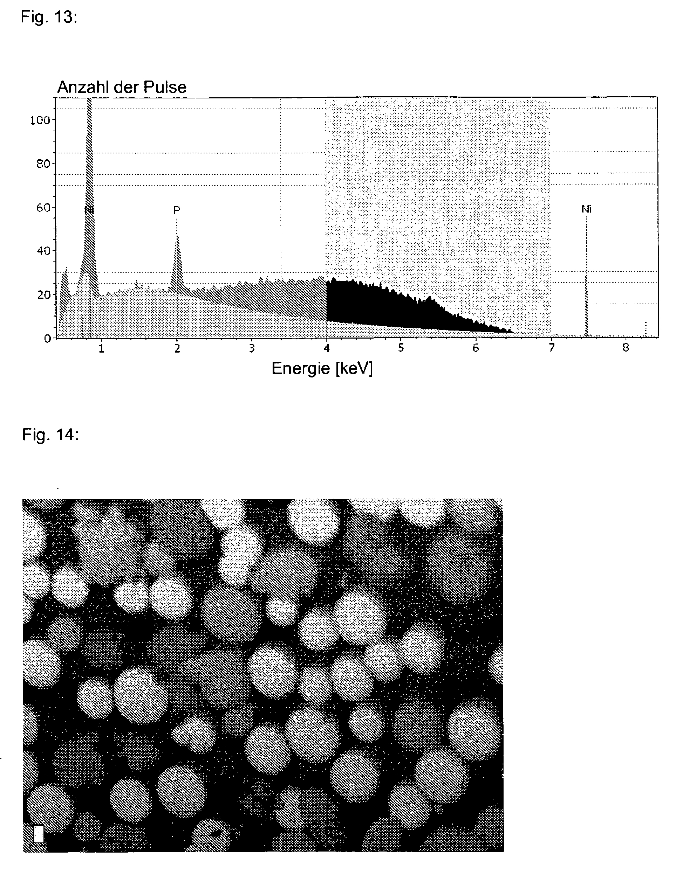

Fig. 13 zeigt die Pulshöhe in eV in Abhängigkeit von der Energie in keV für die NiP-Phase der Fig. 10 (schwarz) sowie den physikalisch berechneten Bremsstrahlungsuntergrundes der Röntgenstrahlung (grau).

Zieht man im Bereich von 4-7 keV von dem schwarz dargestellten Gesamtspektrum den physikalisch berechneten Bremsstrahlungsuntergrund, der durch Röntgenquanten entsteht, ab, bleibt der wesentliche Teil des Rückstreuelektronenbeitrag übrig.

Anstatt wie bei den vorherigen Mappings der Fig. 12 die Intensitäten direkt in einen Graustufenwert umzuwandeln, wurden in Fig. 14 die Intensitäten aus dem Bereich 4-7 keV nach Abzug des theoretischen Bremsstrahlungsuntergrunds in Graustufen umgewandelt, d.h. der Beitrag des Spektrums (im Bild dunkelgrau) in dem Bereich 4-7 keV abzüglich des Untergrundbeitrags in diesem Energiebereich (hellgrau). Dieser Beitrag ist in dem Bild als schwarze Fläche dargestellt, begrenzt durch die graue Fläche. Aus dieser Fläche des Spektrums an jedem Punkt lässt sich ein Mapping erstellen, in dem der Flächengröße bzw. der Countzahl ein Grauwert zugeordnet wird, wie im Folgenden zu sehen ist.

Das Mapping ergibt Bilder, welche einem BSE-Bild sehr ähnlich sehen. Mit Hilfe dieses Mappings kann man anhand der Intensität (Helligkeit) zwischen den drei Phasen unterscheiden: hell: Sn-Phase (hohes Z, viele BSE), mittelhell: Ni-Phase (mittl. Z), dunkel: Cu-Phase (niedriges Z, wenig BSE). Der schwarze Hintergrund besteht aus C, also sehr niedrigem Z mit sehr wenig BSE.

Die Erfindung bezieht sich auf einen energiedispersiven Detektor, der gleichzeitig Röntgenstrahlen und Rückstreuelektronen detektieren kann. Es wurde lediglich beispielhaft und nicht beschränkend anhand einiger Anwendungen dargestellt, wie man die mit dem erfindungsgemäßen Detektor einsetzen und die gemessenen Daten auswerten kann.

### Bezugszeichenliste

- 1: Primärelektronenstrahlquelle
- 2: Rückstreuelektronendetektor
- 3: Probe
- 4: Primärelektronen
- 5: Rückstreuelektronen
- 6: Röntgendetektor
- 7: Röntgenstrahlung / Röntgenphotonen
- 8: Loch
- 9: Elektronik- und Signalverarbeitung
- 10: Detektor für Röntgenstrahlung und Rückstreuelektronen
- 11: Folie
- 12: Detektorelement

## Patentansprüche

1. Detektor (10) zur gleichzeitigen energiedispersiven Aufnahme von Rückstreuelektronen (5) und Röntgenstrahlung (7) nach Anregung einer Probe (3) mit Primärelektronen (4), umfassend:
ein energiedispersives Röntgendetektorelement (12) zur Detektion von Röntgenstrahlung und Rückstreuelektronen,
ein Mittel (11) zur Reduktion des Beitrags der Rückstreuelektronen gegenüber dem Beitrag der Röntgenstrahlung das vor dem Kontgendetektorelement (12) angeordnet ist, characterisiert dadurch, dass das Mittel (11) derart ausgebildet ist, dass
der Beitrag der Rückstreuelektronen (5) gegenüber dem Beitrag der Röntgenstrahlung (7) derart verringert wird, dass die charakteristischen Peaks der Röntgenstrahlung (7) gegenüber dem Messsignal des Rückstreuelektronenbeitrags (5) nachweisbar sind, und gleichzeitig
nach Abzug des theoretischen Röntgenbremsstrahluntergrundes vom gemessenen Spektrum, ein Rückstreuelektronenbeitrag nachweisbar ist.

2. Detektor (10) nach Anspruch 1, wobei ein Beitrag eines Peaks im Spektrum nachweisbar ist, wenn die Peakintensität oder die Peakfläche größer oder gleich ist dem Dreifachen der Quadratwurzel aus der Untergrundintensität unter dem Peak.

3. Detektor (10) nach Anspruch 1 oder 2, wobei das. Mittel (11) derart ausgebildet ist, dass mindestens eines der Merkmale gebildet aus der Gruppe der folgenden Merkmale zutrifft:
die Anzahl der detektierten Rückstreuelektronen (5) weist die gleiche Größenordnung auf wie die Anzahl der detektierten Röntgenphotonen (7);
die Summe der Flächen unter den Röntgenpeaks weist die gleiche Größenordnung auf wie die Fläche des übrigen Untergrundbeitrags abzüglich des theoretischen Bremsstrahluntergrundes;
die Anzahl der Pulse im Maximum des Röntgenpeaks ist mindestens das 1,5fache der Anzahl der Pulse des Untergrundbeitrags des Peaks oder mindestens das Doppelte oder mindestens das Fünffache.

4. Detektor (10) nach einem der vorhergehenden Ansprüche, wobei das Mittel (11) derart ausgebildet ist, dass sich die Anzahl der detektierten Rückstreuelektronen (5) von der Anzahl der detektierten Röntgenquanten (7) um einen Faktor kleiner 100 unterscheidet, bevorzugt um einen Faktor kleiner 50, noch bevorzugter um einen Faktor kleiner 10.

5. Detektor (10) nach einem der vorhergehenden Ansprüche, wobei das Mittel (11) derart ausgebildet ist, dass sich die Summen der Flächen unter den Röntgenpeaks von der Fläche des übrigen Beitrags um einen Faktor kleiner 100 unterscheidet, bevorzugt um einen Faktor kleiner 50, noch bevorzugter um einen Faktor kleiner 10.

6. Detektor (10) nach einem der vorhergehenden Ansprüche, wobei der Detektor (10) in seinem Zentrum ein Loch (8) zum Durchlass von Primärelektronen enthält.

7. Detektor (10) nach einem der vorhergehenden Ansprüche, wobei der Detektor (10) in mehrere Sektoren unterteilt ist, bevorzugt in vier Sektoren.

8. Detektor (10) nach einem der vorhergehenden Ansprüche, wobei der Röntgendetektorelement (12) ein Halbleiterdetektor ist und/oder ein Silizium-Drift-Detektor ist.

9. Detektor (10) nach einem der vorhergehenden Ansprüche, wobei der Detektor (10) derart ausgebildet ist, dass er einen Raumwinkel von 0,5 - 2sr erfasst.

10. Detektor (10) nach einem der vorhergehenden Ansprüche, wobei das Mittel (11) aus Polymeren besteht und/oder aus einem der Elemente aus der Gruppe gebildet aus Polyethylenterephthalat und Poly(p-xylylen) besteht.

11. Detektor (10) nach einem der vorhergehenden Ansprüche, wobei das Mittel (11) eine Folie ist.

12. Detektor nach Anspruch 11, wobei
für eine Anregungsenergie von Primärelektronen (4) kleiner 10 keV die Foliendicke weniger als 3 µm beträgt, bevorzugt 1,5-2,5 µm und/oder
für eine Anregungsenergie von Primärelektronen (4) von größer gleich 10 keV und kleiner 15 keV die Foliendicke 3-5 µm beträgt, bevorzugt 3,5-4,5 µm und/oder
für eine Anregungsenergie von Primärelektronen (4) von größer gleich 15 keV bis kleiner 25 keV die Foliendicke 5-9 µm beträgt, bevorzugt 7,5-8,5 µm.

13. Vorrichtung zur simultanen Messung von Röntgenstrahlen (7) und Rückstreuelektronen (5), umfassend:
eine Primärelektronenstrahlquelle (1);
einen Probenhalter, angeordnet im Emissionsbereich der Elektronenstrahlquelle (1);
einen Detektor (10) nach einem der Ansprüche 1-12, angeordnet im Elektronenstrahlgang zwischen Primärelektronenstrahlquelle (1) und Probenhalter, und
ein Mittel zur Auswertung der Messdaten.

14. Vorrichtung nach Anspruch 13, wobei der Abstand zwischen Probehalter und Detektor (10) im Bereich von 2 bis 40 mm liegt, bevorzugt 10-30 mm.

15. Verfahren zur gleichzeitigen Messung von Rückstreuelektronen und Röntgenstrahlung mit einer Vorrichtung nach Anspruch 13 oder 14, umfassend die Schritte:
Bestrahlung einer Probe mit Primärelektronen (4);
Rückstreuung von Elektronen von der Probe (3) auf den Detektor (10) und gleichzeitige Bestrahlung des Detektors (10) mit Röntgenstrahlung (7) von der Probe (3),
**dadurch gekennzeichnet, dass**
der Beitrag der Rückstreuelektronen (5) vor dem Röntgendetektorelement (12) derart reduziert wird, dass
der Beitrag der Rückstreuelektronen (5) gegenüber dem Beitrag der Röntgenstrahlung (7) derart verringert wird, dass die charakteristischen Peaks der Röntgenstrahlung (7) gegenüber dem Messsignal des Rückstreuelektronenbeitrags (5) nachweisbar sind, und gleichzeitig
nach Abzug des theoretischen Röntgenbremsstrahluntergrundes vom gemessenen Spektrum, ein Rückstreuelektronenbeitrag nachweisbar ist.

16. Verfahren nach Anspruch 15, wobei der Beitrag der Rückstreuelektronen (5) gegenüber dem Beitrag der Röntgenstrahlung (7) derart verringert wird, dass mindestens eines der Merkmale gebildet aus der Gruppe der folgenden Merkmale zutrifft:
die Anzahl der detektierten Rückstreuelektronen (5) weist die gleiche Größenordnung auf wie die Anzahl der detektierten Röntgenphotonen (7);
die Summe der Flächen unter den Röntgenpeaks weist die gleiche Größenordnung auf wie die Fläche des übrigen Untergrundbeitrags abzüglich des theoretischen Bremsstrahluntergrundes;
die Anzahl der Pulse im Maximum des Röntgenpeaks ist mindestens das 1,5fache der Anzahl der Pulse des Untergrundbeitrags in der direkten Umgebung des Peaks oder mindestens das Doppelte oder mindestens das Fünffache.

17. Verfahren nach Anspruch 15 oder 16, wobei zur Auswertung der Messdaten der theoretisch berechnete Röntgenbremsstrahluntergrund von den energieaufgelösten Messdaten abgezogen wird.

18. Verfahren nach Anspruch 17, wobei die Subtraktion im Bereich des asymptotischen Abfalls der theoretisch berechnete Röntgenbremsstrahluntergrund vorgenommen wird und dann durch Auswertung der Spektren an jedem Punkt der Oberfläche ein Mapping erstellt wird, indem der Flächengröße bzw. der Countzahl ein Grauwert oder Farbwert zugeordnet wird.

## Claims

1. A detector (10) for the simultaneous energy-dispersive recording of backscattered electrons (5) and X-radiation (7) after excitation of a sample (3) with primary electrons (4), comprising:
an energy-dispersive X-ray detector element (12) for the detection of X-radiation and backscattered electrons,
a means (11) for reducing the contribution of backscattered electrons compared to the contribution of the X-radiation, said means being arranged in front of the X-ray detector element (12),
**characterized in that** the means (11) is designed such that
the contribution of the backscattered electrons (5) is reduced compared to the contribution of the X-radiation (7) such that the characteristic peaks of the X-radiation (7) can be detected with respect to the measuring signal of the backscattered electron contribution (5) and at the same time,
after deduction of the theoretical X-ray bremsstrahlung background from the measured spectrum, a backscattered electron contribution can be detected.

2. The detector (10) according to claim 1, wherein a contribution of a peak in the spectrum can be detected when the peak intensity or the peak area is larger than or equal to three times the square root of the background intensity underneath the peak.

3. The detector (10) according to claim 1 or 2, wherein the means (11) is designed such that at least one of the features from the group of the following features applies:
the number of the detected backscattered electrons (5) has the same magnitude as the number of the detected X-ray photons (7);
the sum of the areas underneath the X-ray peaks has the same magnitude as the area of the remaining background contribution, minus the theoretical bremsstrahlung background;
the number of pulses in the maximum of the X-ray peak is at least 1.5 times the number of the pulses of the background contribution of the peak or at least twice or at least five times as large.

4. The detector (10) according to any one of the preceding claims, wherein the means (11) is designed such that the number of the detected backscattered electrons (5) differs from the number of the detected X-ray quanta (7) by a factor smaller than 100, preferably by a factor smaller than 50, more preferably by a factor smaller than 10.

5. The detector (10) according to any one of the preceding claims, wherein the means (11) is designed such that the sums of the areas underneath the X-ray peaks differs from the area of the remaining contribution by a factor smaller than 100, preferably by a factor smaller than 50, more preferably by a factor smaller than 10.

6. The detector (10) according to any one of the preceding claims, wherein the detector (10) in its center contains a whole (8) for letting primary electrons pass through.

7. The detector (10) according to any one of the preceding claims, wherein the detector (10) is divided into multiple sectors, preferably into four sectors.

8. The detector (10) according to any one of the preceding claims, wherein the X-ray detector element (12) is a semiconductor detector and/or a silicon drift detector.

9. The detector (10) according to any one of the preceding claims, wherein the detector (10) is designed such that it covers a solid angle of 0.5 to 2 sr.

10. The detector (10) according to any one of the preceding claims, wherein the means (11) consists of polymers and/or of one of the elements from the group of polyethylene terephthalate and poly(p-xylylene).

11. The detector (10) according to any one of the preceding claims, wherein the means (11) is a foil.

12. The detector according to claim 11, wherein
for an excitation energy of primary electrons (4) smaller than 10 keV the foil thickness is less than 3 µm, preferably 1.5 to 2.5 µm, and/or
for an excitation energy of primary electrons (4) larger than or equal to 10 keV and smaller than 15 keV, the foil thickness is 3 to 5 µm, preferably 3.5 to 4.5 µm, and/or
for an excitation energy of primary electrons (4) larger than or equal to 15 keV to smaller than 25 keV, the foil thickness is 5 to 9 µm, preferably 7.5 to 8.5 µm.

13. A device for the simultaneous measurement of X-rays (7) and backscattered electrons (5), comprising:
a primary electron beam source (1);
a sample holder, arranged within the emission range of the electron beam source (1);
a detector (10) according to any one of claims 1 to 12, arranged in the electron beam path between the primary electron beam source (1) and the sample holder, and
a means for analyzing the measured data.

14. The device according to claim 13, wherein the distance between the sample holder and the detector (10) is within the range of 2 to 40 mm, preferably 10 to 30 mm.

15. A method for the simultaneous measurement of backscattered electrons and X-radiation with a device according to claim 13 or 14, comprising the steps of:
irradiating a sample with primary electrons (4);
backscattering of electrons from the sample (3) onto the detector (10) and simultaneously irradiating the detector (10) with X-radiation (7) from the sample (3),
**characterized in that**
the contribution of the backscattered electrons (5) in front of the X-ray detector element (12) is reduced such that
the contribution of the backscattered electrons (5) is reduced compared to the contribution of the X-radiation (7) such that the characteristic peaks of the X-radiation (7) can be detected with respect to the measuring signal of the backscattered electron contribution (5) and at the same time,
after deduction of the theoretical X ray bremsstrahlung background from the measured spectrum, a backscattered electron contribution can be detected.

16. The method according to claim 15, wherein the contribution of the backscattered electrons (5) is reduced compared to the contribution of the X-radiation (7) such that at least one of the features from the group of the following features applies:
the number of the detected backscattered electrons (5) has the same magnitude as the number of the detected X-ray photons (7);
the sum of the areas underneath the X-ray peaks has the same magnitude as the area of the remaining background contribution, minus the theoretical bremsstrahlung background;
the number of pulses in the maximum of the X-ray peak is at least 1.5 times the number of the pulses of the background contribution in the direct environment of the peak or at least twice or at least five times as large.

17. The method according to claim 15 or 16, wherein for the analysis of the measured data the theoretically calculated X-ray bremsstrahlung background is deducted from the energy-dispersive measured data.

18. The method according to claim 17, wherein the subtraction is performed within the range of the asymptotic drop of the theoretically calculated X-ray bremsstrahlung background and then a mapping is produced by analyzing the spectra at each point of the surface, assigning a gray value or a color value to the area size or the count number.

## Revendications

1. Détecteur (10) pour l'enregistrement simultané à dispersion d'énergie d'électrons rétrodispersés (5) et de rayons X (7) après l'excitation d'un échantillon (3) par des électrons primaires (4), comprenant :
un élément de détecteur de rayons X (12) à dispersion d'énergie pour la détection du rayonnement X et d'électrons rétrodispersés,
un moyen (11) pour la réduction de la contribution des électrons rétrodispersés par rapport à la contribution du rayonnement X, qui est disposé devant l'élément de détecteur de rayons X (12),
**caractérisé en ce que** le moyen (11) est constitué de telle sorte que
la contribution des électrons rétrodispersés (5) par rapport à la contribution du rayonnement X est réduite de telle sorte que les pics caractéristiques du rayonnement X par rapport au signal de mesure de la contribution des électrons rétrodispersés (5) sont détectables, et simultanément,
après la déduction de l'arrière-plan théorique du rayonnement de freinage des rayons X du spectre mesuré, une contribution des électrons rétrodispersés est détectable.

2. Détecteur (10) selon la revendication 1, une contribution d'un pic dans le spectre étant détectable quand l'intensité du pic ou la surface du pic est supérieure ou égale au tiers de la racine carrée extraite de l'intensité de l'arrière-plan sous le pic.

3. Détecteur (10) selon la revendication 1 ou 2, le moyen (11) étant constitué de telle sorte qu'au moins une des caractéristiques formée à partir du groupe des caractéristiques suivantes est présente :
le nombre d'électrons rétrodispersés (5) détectés présente le même ordre de grandeur que le nombre de photons X détectés (7) ;
la somme des surfaces sous les pics de rayonnement X présente le même ordre de grandeur que la surface du reste de la contribution d'arrière-plan moins l'arrière-plan théorique de rayonnement de freinage ;
le nombre d'impulsions dans le maximum du pic de rayonnement X est au moins 1,5 fois le nombre d'impulsions de la contribution de l'arrière-plan du pic ou au moins deux fois ou au moins cinq fois ce nombre.

4. Détecteur (10) selon une des revendications précédentes, le moyen (11) étant constitué de telle sorte que le nombre d'électrons rétrodispersés (5) détectés se différencie du nombre de rayons X (7) détectés d'un facteur inférieur à 100, de préférence d'un facteur inférieur à 50, de façon encore plus préférée d'un facteur inférieur à 10.

5. Détecteur (10) selon une des revendications précédentes, le moyen (11) étant constitué de telle sorte que les sommes des surfaces sous les pics de rayonnement X se différencie de la surface du reste de la contribution d'un facteur inférieur à 100, de préférence d'un facteur inférieur à 50, de façon encore plus préférée d'un facteur inférieur à 10.

6. Détecteur (10) selon une des revendications précédentes, le détecteur (10) contenant en son centre un trou (8) pour le passage d'électrons primaires.

7. Détecteur (10) selon une des revendications précédentes, le détecteur (10) étant divisé en plusieurs secteurs, de préférence en quatre secteurs.

8. Détecteur (10) selon une des revendications précédentes, l'élément de détecteur de rayons X (12) étant un détecteur à semi-conducteurs et/ou un détecteur au silicium à diffusion.

9. Détecteur (10) selon une des revendications précédentes, le détecteur (10) étant constitué de telle sorte qu'il forme un angle solide de 0,5 - 2 sr.

10. Détecteur (10) selon une des revendications précédentes, le moyen (11) étant composé de polymères et/ou étant composé d'un des éléments appartenant au groupe formé de polyéthylène téréphtalate et de poly(p-xylylène).

11. Détecteur (10) selon une des revendications précédentes, le moyen (11) étant une feuille.

12. Détecteur (10) selon la revendication 11,
l'épaisseur de feuille étant, pour une énergie d'excitation d'électrons primaires (4) inférieure à 10 keV, inférieure à 3 µm, de préférence comprise entre 1,5 et 2,5 µm et/ou
l'épaisseur de feuille étant, pour une énergie d'excitation d'électrons primaires (4) supérieure ou égale à 10 keV et inférieure à 15 keV, comprise entre 3 et 5 µm, de préférence entre 3,5 et 4,5 µm et/ou
l'épaisseur de feuille étant, pour une énergie d'excitation d'électrons primaires (4) supérieure ou égale à 15 keV et jusqu'à inférieure à 25 keV, comprise entre 5- et 9 µm, de préférence entre 7,5 et 8,5 µm.

13. Dispositif de mesure simultanée de rayons X (7) et d'électrons rétrodispersés (5), comprenant :
une source de rayonnement d'électrons primaires (1) ;
un porte-échantillon, disposé dans la zone d'émission de la source de rayonnement d'électrons primaires (1) ;
un détecteur (10) selon une des revendications 1-12, disposé sur le passage de rayonnement d'électrons entre la source de rayonnement d'électrons primaires (1) et le porte-échantillon, et
un moyen d'analyse des données de mesure.

14. Dispositif selon la revendication 13, l'intervalle entre le porte-échantillon et le détecteur (10) étant dans la plage de 2 à 40 mm, de préférence de 10 à 30 mm.

15. Procédé de mesure simultanée d'électrons rétrodispersés et de rayonnement X avec un dispositif selon la revendication 13 ou 14, comprenant les étapes suivantes :
exposition d'un échantillon à des électrons primaires (4) ;
rétrodispersion d'électrons depuis l'échantillon (3) vers le détecteur (10) et exposition simultanée du détecteur (10) à un rayonnement X (7) provenant de l'unité de réception (3),
**caractérisé en ce que**
la contribution des électrons rétrodispersés (5) devant l'élément de détecteur de rayons X (12) est réduite de telle sorte que
la contribution des électrons rétrodispersés (5) par rapport à la contribution du rayonnement X (7) est réduite de telle sorte que les pics caractéristiques du rayonnement X (7) par rapport au signal de mesure de la contribution des électrons rétrodispersés sont détectables, et simultanément
une contribution des électrons rétrodispersés est détectable après la déduction de l'arrière-plan théorique de freinage des rayons X du spectre mesuré.

16. Procédé selon la revendication 15, la contribution des électrons rétrodispersés (5) par rapport à la contribution du rayonnement X (7) étant réduite de telle sorte qu'au moins une des caractéristiques formée à partir du groupe des caractéristiques suivantes est présente :
le nombre d'électrons rétrodispersés (5) détectés présente le même ordre de grandeur que le nombre de photons X détectés (7) ;
la somme des surfaces sous les pics de rayonnement X présente le même ordre de grandeur que la surface du reste de la contribution d'arrière-plan moins l'arrière-plan théorique de rayonnement de freinage ;
le nombre d'impulsions dans le maximum du pic de rayonnement X est au moins 1,5 fois le nombre d'impulsions de la contribution de l'arrière-plan du pic au voisinage direct du pic, ou au moins deux fois ou au moins cinq fois ce nombre.

17. Procédé selon la revendication 15 ou 16, l'arrière-plan du rayonnement de freinage des rayons X calculé théoriquement étant, pour l'analyse des données de mesure, soustrait des données de mesure à résolution en énergie.

18. Procédé selon la revendication 17, la soustraction étant effectuée dans la plage de la diminution asymptotique de l'arrière-plan du rayonnement de freinage de rayons X calculé théoriquement, et puis un mappage étant établi par l'analyse des spectres en chaque point de la surface par le fait qu'une valeur de gris ou une valeur de couleur est affectée à la dimension de surface ou au comptage.
